# EUROPEAN PATENT SPECIFICATION

(11) **EP 1 950 791 B1**
(45) Date of publication and mention of the grant of the patent: **11.02.2009**
(21) Application number: 08156368.6
(22) Date of filing: 24.06.2005
(51) Int. Cl.: H01L 21/00, H01L 21/66

(54) **Bonding machine for applying transponders and method**
Bonding Maschine um Transponder zu befestigen und Verfahren
Machine à connecter des transpondeurs et procédé

(30) Priority: 24.06.2004 US 582741 P; 08.12.2004 US 634190 P
(43) Date of publication of application: 30.07.2008
(62) Divisional of application: 05764304.1
(73) Proprietor: Checkpoint Systems, Inc., Thorofare, NJ 08086 (US)
(72) Inventor: Eckstein, Eric, Merion Station, PA 19066 (US); Clare, Thomas, Media, PA 19063 (US); Cote, Andre, Williamstown, NJ 08094 (US)
(74) Representative: Menges, Rolf

(56) References cited:
- WO-A-00/21032
- PATENT ABSTRACTS OF JAPAN vol. 2003, no. 04, 2 April 2003 (2003-04-02) & JP 2002 353283 A (SONY CORP), 6 December 2002 (2002-12-06)

## Description

### FIELD OF INVENTION

This invention is related to security tags, and, in particular, to bonding integrated circuits (ICs) uniquely suited to high volume tag production.

### BACKGROUND OF THE INVENTION

Chip bonding is costly. The two largest components of the cost of RFID tags today are the integrated circuit and the attachment of that circuit to an antenna structure. Moore's law and increasing volume are helping to drive the IC cost down, but bonding is a mechanical process and does not benefit from the same technology advances or economies of scale.

Current methods of chip bonding do not adequately address cost. A two-step approach of an intermediary "strap" achieves incremental cost improvement by relocating the costs. However, straps do not address the problem directly, as bonding is still required, but to a smaller tag. Moreover, straps add another step to bond the strap to the big tag.

Current manufacturers using standard bonding technology with straps, want straps to be like traditional bonding surfaces, that is, hard and inflexible. But such straps do not lend themselves to easy integration into squishy flexible tags. The known standard bonding processes are all strap-based solutions, and therefore less than ideal.

One related art bonding method, called fluid self-assembly, provides insufficiently robust bonds. Because the chips find their own way into bonding sockets, the chips cannot use any adhesives or flux, since anything sticky prevents free motion of the chip into the sockets. Then the bond is made at a tangent between the chip bonding pad and the side of the bonding cavity. This flat-to-edge bond is different than and less reliable than traditional bonds, which are made flat-to-flat. As an analogous example illustrating problems inherent to flat-to-edge bonds, consider trying to stand a playing card on edge, rather than laying it flat on a table. Fluid self-assembly also places restrictions on the type of substrate that can be used. This may not be a problem for just making straps; but it is certainly a problem for foregoing the strap and putting the chip right on the tag.

A known bonding process is a gallant brute force attempt to make standard bonding faster. Instead of having one vacuum head pick up one chip and place it on one strap, a plurality of heads (*e.g*., 60) in lock step picks up that number (*e.g.*, 60) of chips and puts them on that number (*e.g*., 60) of straps. This process suffers from the problem of keeping all of the number (*e.g*., 60) of chips aligned correctly at the same time.

Bonding RFID chips is more like processing diodes and resistors than processing other kinds of chips. One new RFID strap line uses a traditional tape automated bonding process, with a sprocket-fed 35 mm tape of hard straps inching its way through a traditional flip-chip placement and bonding head. At 4.75 mm pitch, four lanes wide, and 10,000 chip bonds per hour, their tape advances through the bonding procedure at about 0.65 feet per minute. It would be beneficial if a chip bonding process could produce more bonded chips in less time.

In order to consider why the art has not bonded chips as exemplified by the preferred embodiments of the invention discussed below, it may help to compare standard electronic chip components to RFID tags. Standard electronic chip components are known and generally found on printed circuit boards. A bare IC is bonded to a carrier by wire bonding or flip chip. Then a package is molded around the carrier and chip. The package is then put onto a printed circuit board via thru-hole or surface mount assembly. In summary, typical standard chip components: need to be compatible with multiple PCB assembly technologies, including solder baths, solder waves, IR reflow, and a variety of cleaning and baking steps; want more and more computational power put in single chip assemblies; and are made to last. In contradistinction, RFID tags: are never soldered or baked or cleaned; are complete unto themselves and do not have to be integrated into any other system; want the bare minimum computational power to minimize cost and energy consumption (which translates into read distance); and do not face the same power dissipation or environmental requirements as standard chips.

To meet their design requirements, standard chip assemblies usually start with relatively stiff and heavy substrates, at least compared to RFID tags. Ceramics and fiberglass are common. These are meant to be tough and resinstant to thermal influences. Usually the standard chip substrates are etched. Laser cutting is expensive because the standard chip substrates are thick and have high thermal masses.

RFID tags are substantially different. The metal layer is thin and flexible (or non-rigid) by comparison. The back or substrate of each tag is soft polypropylene or paper. The substrates are easily to punch, cut, dimple, and weld. The preferred embodiments of the invention reinvent bonding taking advantage of these different properties.

JP-A-2002 353 283 discloses a method and an apparatus for distinguishing amongst semiconductor chips to be bonded to a substrate. A semiconductor chip is distinguished by a monitoring chip which is related to the semiconductor chip. When the circuit pattern of the monitoring chip corresponds to a designated circuit pattern, the semiconductor chip is selected as a product to be bonded.

A known wire bonding process is disclosed in US-A-5 708 419, wherein the bonding of an IC to a flexible or non-rigid substrate which generally can not be subjected to high temperatures, such as the temperature required for performing soldering processes, is discussed. In this wire bonding process, a chip or dye is attached to a substrate or carrier with conductive wires. The chip is attached to the substrate with the chip front-side face up. Conductive wires are bonded first to the chip, then looped and bound to the substrate. The steps of a typical wire bonding process include:
1. advancing web to the next bond site
2. stopping
3. taking a digital photograph of the bond site
4. computing bond location
5. picking up a chip
6. moving the chip to the bond site
7. using photo feedback to adjust placement to the actual site location
8. placing or depositing chip
9. photographing the chip to locate the bond pads
10. moving the head to the chip bond pad
11. pressing down, vibrating and welding conductive wire to the bond pad
12. pulling up and moving the chip to the substrate bond pad, trailing wire back to the chip bond
13. pressing down and welding that bond
14. pulling up and cutting off the wire; and
15. repeating steps 10-14 for each connection

In contrast, the interconnection between the chip and substrate in flip-chip packaging is made through conductive bumps of solder that are placed directly on the chip surface. The bumped chip is then flipped over and placed face down, with the bumps electrically connecting to the substrate.

Flip chip bonding, a current state of the art process, is expensive because of the need to match each chip to a tiny, precision-cut bonding site. As chips get smaller, it becomes even harder to precisely cut the bonding site. However, the flip-chip bonding process is a considerable advancement over wire bonding. The steps of a typical flip-chip bonding process include:
1. advancing web to the next bond site
2. stopping
3. photographing the bond site
4. computing the bond location
5. picking up the chip
6. moving the chip to the bond site
7. using photo feedback to adjust placement at the actual site location
8. placing the chip
9. ultrasonically vibrating the placement head to weld chip in place; and
10. retracting the placement head

Steps 1 through 8 of each of the above bonding processes are substantially the same. The web must stop to locate the conductive gap in the substrate and precisely place the IC. The related art processes require that the web is stopped and measured (*e.g*., photographing the bond site, containing the bond location, using photo feedback to adjust placement at the actual site location) so that the chip can be accurately placed as desired adjacent the gap and bonded.

In designing an efficient chip placement process that can be integrated into RFID tags, the inventors discovered that it is beneficial to avoid anything that is not consistent with a continuous rolling printing press. Stopping and starting the line always slows things down. It would be beneficial to adjust tooling to operate on a chip that is continuously advancing down the line at a known rate of travel.

Retracing a path during the bonding process takes time, causes vibration, and wears mechanical linkages. These linkages also create uncertainty in absolute position. Rotating or continuous devices are thus preferred over reciprocating devices.

The greater the number of mechanical connections in a bonding process, the less certainty there is in precise position. Every jointed or flexible linkage introduces a certain amount of randomness as the web and chips wiggle around. IC dimensions are tiny. It does not take a lot of mechanical links to move chip placement out of critical alignment.

With security tags, you cannot rely on any precise dimension set previously. The relative position of things varies across the web, from one end of the roll to another, from place to place, and from time to time. That is simply the reality of working with inexpensive materials. For IC bonding processes, the manufacturer must constantly adapt to how the material is really behaving, rather than counting on it to behave as intended.

### BRIEF SUMMARY OF THE INVENTION

An integrated circuit bonding process according to the preferred embodiments provides:
- A high quality and high reliability integrated circuit attachment to a tag or strap;
- Bonding speeds compatible with flexographic printing lines, and thereby suitable for integration in current and foreseeable tag production lines; and
- Low total bond costs, for example, of less than $0.01 at production volumes.

While not being limited to a particular theory, the preferred embodiments of the present invention illustrate approaches for cutting a bond site and assembly placing a chip (*e.g.*, transponder) at the bond site without stopping the web. That is, the chip substrates move continuously during the chip placement process. According to the invention, the bond site is cut to form a gap where a chip is expected to be placed. According to the preferred embodiments of the present invention, a manufacturer can achieve bonding rates for tiny chips 100 times faster than the conventional technology, in particular, by applying the bonding process on chip substrates moving continuously at a speed normally applicable to high speed printing presses in the flexographic process range of up to at least about 300 feet per minute.

### BRIEF DESCRIPTION OF SEVERAL VIEWS OF THE DRAWINGS

The invention will be described in conjunction with the following drawings in which like reference numerals designate like elements and wherein:
Fig. 1 shows a table of chip locations during a time sequence in accordance with the preferred embodiments of the invention;
Fig 2. illustrates a structural representation of a cut-on-fly apparatus in accordance with the preferred embodiments;
Fig. 3 illustrates a chip placement approach in accordance with the preferred embodiments of the invention.

### DETAILED DESCRIPTION OF PREFERRED EMBODIMENTS OF THE INVENTION

According to the preferred embodiments, RFID chips are bonded on soft, mutable substrates. The chips are prepared for bonding according to known chip prepping methods. As one example, the chips are topped with quartz - silicon dioxide - with little windows etched down to aluminum contact pads. These contact pads are "bumped" with solder by either sputtering the solder on or running the wafer across a solder wave bath. The solder sticks to the aluminum and slides away from the quartz.

The preferred bonding process starts with a completed silicon wafer, which contains thousands of integrated circuits (ICs) etched into a single plate of silicon material. The completed silicon wafer is cut into hundreds of the individual chips, with each chip including an IC and its corresponding section of the silicon plate.

Wafers with big chips (e.g., 1,61 cm² to 6,46 cm² or 0.25 in² to 1.0 in²) on them are normally cut apart with delicate diamond saws. In comparison, RFID chips are really, really tiny (*e.g*., 50 µm x 100 µm), and sawing the wafer apart is not economical. For RFID chips, the wafer is grinded on the backside to make the wafer as thin as possible while being supportive as desired. Then the thinned wafer is masked with acid-resist for protection, except in the places of the wafer that we want to cut. This is known as a standard wafer operation.

Next the whole wafer is dipped in acid. The acid eats away the unprotected silicon between chips until the wafer breaks apart into thousands of chips. Using a strainer to keep the chips from flushing away, the acid is rinsed out of the bath leaving thousands of RFID chips floating in a bottle of water. The chips are poured out of the solution and dried. Using this standard technology, a wafer is separated into numerous chips without frictional (*e.g*., saw) cutting.

Most chip bonding processes struggle to either get the chip lined with the substrate or get both the substrate and the bond site lined up. However, the preferred embodiments do not need that same level of precision as previously required for chip placement. While not being limited to a particular theory, the preferred bonding approach described in greater detail below just needs to get all the chips facing about the same direction.

A shaker table, as known in the art, accomplishes the goal of chip orientation. To begin, a jumble of chips is placed on a funnel-shaped shaking table leading to a small square or rectangular (*e.g*., tens hundreds, thousands) alignment tube. The chips are typically substantially box-like rectangular prisms, possibly having slanted sides from the etching process. The chips are shaken into the tube, ending up in one of eight orientations. Then a picture of the shaker chips is taken. If a chip is in the right orientation, it continues down the tube. If a chip is not in the correct orientation, then the disoriented chip is kicked back onto the shaker table for another orientation attempt. Eventually all the chips end up in the tube in the right orientation.

In stark contrast to prior art approaches that prepare the bond site for the IC before the substrate goes into the bonding machine, the preferred approach of this invention lets the bonding machine itself make the cut. What goes into the machine for the bonding site is solid metal. For example, the metal is preferably a thin strip of metal film on a strap, a web of tags, packaging material, or a product. The important thing is that, according to the preferred embodiments, the bond site is not prepared (*e.g*., formed with a conductive gap) before the metal is input to the bonding machine. According to the preferred embodiments, what goes into the bonding machine is a blank metal strip, ready to be cut for its particular chips.

It is understood that a shaker table is one of various approaches to accomplish chip orientation before chip placement at a bond site, and that the invention is not limited to this particular approach. In fact, the preferred cut-on-fly method is applicable to a chip attached to its substrate, or to a chip about to be attached to its substrate, or to a chip being attached to its substrate. Accordingly, the manner in which the chip is attached to its substrate is not a limiting factor to the preferred methods for cutting the substrate, as long as the chip is attached or oriented for attachment to the substrate, as discussed, by example, in greater detail below. Another approach that accomplishes chip orientation, for example by formation of the chip on a metal substrate is disclosed in US 2005/0183817 A1, US 2005/0184873 A1 and US 2005/0184872 A1, all filed on November 24, 2004 and published on August 25, 2005.

Now it is not enough that the machine makes a cut. The cut must form a conductive gap in the metal strip. That is, the conductive strip or substrate material must be removed completely at the gap to avoid the risk that it will short out the chip later. There are at least two-ways to down this. One is called a "kiss cut" achieved with cutting blades. Another is ablation with a laser - literally vaporizing the unwanted metal. Lasers are preferred because laser cutters can make a precise cut without bringing anything mechanical in touch with the substrate. But, whether by kiss cut, laser or an equivalent approach (e.g., wafer), the bonding machine of the preferred embodiments can make this cut without ever slowing the web down. That is, the web is continuously moving when the gap is formed by the cut, and during chip placement, for example, at flexographic printing speed. Moreover, the cut is made within the tolerance allowed by small RFID chips having a size of, for example, about 100 microns or less. The tolerance allowed to create a gap between contact points of the chip is less than about 80 microns, and more preferably, less than about 20-30 microns.

The preferred examples of the embodiments discuss the invention with relation to chips (*e.g*., transponders) having two conductive pads requiring electrical connections to an antenna at a die attach site with a gap formed from a single cut. It is understood, however, that the invention is not limited to that scope, as the preferred embodiments apply to other types of chips (*e.g*., multi-padded chips) as well. Of course, multi-padded chips need more cuts, which is easily provided, especially using laser cutters, which can cut the conductive substrate or carrier in a preconfigured pattern as desired.

The width of the cut, in particular a laser cut, is largely a function of the pattern and the magnitude of energy applied. The width is also a function of the thickness of the conductive substrate, as the thicker the substrate, the more difficult it is to get a clean narrow cut. Using pulse control laser cutting, femto second resolution is possible. For micromachining, water saws are another preferred approach for cleaning the kerf. Regardless of the cutting approach, the preferred cut width is about 5 µm or less.

To avoid wimpy unstable bonds, the bonding machine of the preferred embodiments welds the chips to the substrate. The preferred bond is with a solder weld, and for that it is nice to use flux, perhaps even acid flux. There is no need for exact precision. Flux is simple squirted over the bond area for each solder weld. The flux forms a pre-defined boundary that solder bumps (*e.g*., flip, chip, controlled chip collapse) of the chip don't go beyond. The solder bumps adhere to the flux and orient to the metal along the web direction.

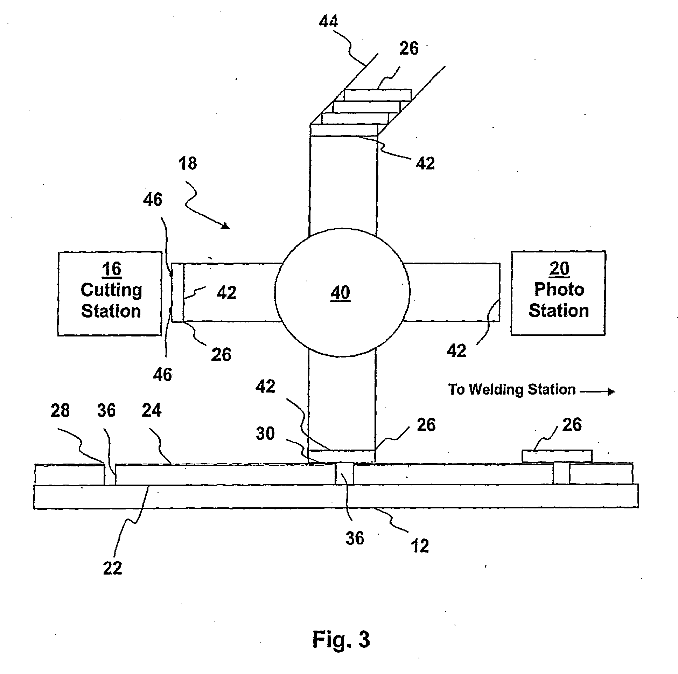

There are various approaches to transfer the chips (*e.g*., transponders) from the alignment tube of, for example, a shaker table, to the sticky flux over the bond area as the web goes by. One approach for depositing or placing chips is to tip the chips on, letting the chips contact the moving flux such that a leading end of the chips stick to and get pulled out by the flux, one at a time. Another approach is to shoot the chips onto the flux with air pressure. A preferred approach is to stick the aligned chips with a rotating wheel of vacuum heads. For example, as shown in Fig 3, each head sucks a chip out of the alignment tube at the top of the wheel's turn, and blows it onto the bond site on the bottom of its turn. It is preferable to place or deposit the chip upside down in the flux, so that the chip's solder bumps are pressed right into the conductive material (*e.g*., metal strip) for connection at the bonding site.

While not being limited to a particular theory, the chip placement can be achieved without slowing the web down to place the chips. The web keeps whizzing by, and the bonding machine places a chip onto the moving web as desired, for example, every time an available chip flux spot shows up. This approach for chip bonding on soft substrate thus is more like mechanical assembly processing than like anything used in standard IC processing.

Next, in the preferred embodiments, a picture is taken to determine where the chip landed. From that picture the bonding machine can compute where it should or should have cut the metal strip to make the bonding site for that chip. That is, this photo information can be used to determine where to make the cut after the chip is placed. As discussed in greater detail below, the photo information can also be used to cut the conductive material (*e.g*., metal strip) at the bond site before the chip is attached to the conductive material.

The preferred approach described herein creates a conductive gap in the antenna right where the chip is sitting or expected to sit. The most preferred embodiments take the information of where this bond site should be, and uses this information to cut the bond site for a chip that has not been placed onto its bond site. In other words, the optical or alignment feedback of a placed chip is used to determine and cut the bond site for a subsequent pre-bonded chip (*e.g*., the next chip) yet to be placed.

The preferred embodiments use photo feedback because while the chips do not change in dimension, the substrates do change - especially soft substrates. On a roll of tags, which may be made in one location (*e.g*., Puerto Rico) and bonded in another location (*e.g*., Sweden), the difference in the location of a pre-cut bond site from one end of the roll to the other end is much larger than reasonably allowable for the chips. Webs and rolls stretch; machines wobble; components heat up and expand. Thus when a tag is brought into a bonding machine, the bonding machine does not know and cannot predict exactly where the bond site will be. However, if the bonding machine knows where the last bond site should have been, there is no substantial error in placing the current or next bond site there. In other words, there is no substantial error in placing a next or subsequent chip based on the location of a previous chip.

In fact, the difference between one, two, three, or maybe even ten bond sites in a row is small (*e.g*., almost zero, nearly identical in placement) and insignificant as within the allowable margin of error between the contact pads of the chips (*e.g*., about 10 to 30 µm). So it is not necessary for the bonding machine to place a chip based on the photographed location of the previous chip. The bonding machine has more time to process the photo and can use the photo of a deposited chip to place a subsequent chip several chips removed from the photographed chip. The cutting device just makes the cut that much longer before the photo step. However, the little errors add up, for example, 50 tags later the cutting device may not make the right cut between the expected location of the contact pads with certainty. With a million tags on a roll, there is no way that one cut position is right for all of the chips.

Accordingly, the most preferred embodiments of the invention use alignment feedback. The inventors have discovered that a preferred way to use alignment feedback is to locate a deposited chip to make the cut for a subsequent chip before that subsequent chip is placed. It is understood that the invention is not limited to a placement machine that uses photo feed back. In fact, as will be described in greater detail below, alignments can be accomplished by approaches other than photo. For example, the placement of a chip and cutting of the die attach area could be aligned based on the placement of the flux.

After the chips are deposited on to their respective bond site, they are welded to the metal substrate. Solder welds are preferred because they do not corrode, they provide mechanical strength, and they form a metallurgical bond for superior conduction. That is, a closer weld provides a high quality and highly reliable conductive attachment. The preferred soldering technique is a type of flip-chip soldering known as controlled chip collapse.

In the preferred embodiments, the solder is present as bumps on the chip placed onto the flux. Heat is applied to the solder, but not too much heat. The preferred amount of heat is sufficient to get the surface of the flux and substrate adjacent the flux hot, and liquefy the solder, but not to burn or deform the substrate. The substrate is soft, possibly with a plastic layer if the bonding machine is bonding to an etched tag, so excessive heat should be avoided. Flash fusing (*e.g*., with a xenon bulb) is preferred for the solder weld. Xenon tube flash fusing is currently used, for example, in laser printers.

It is understood that there are numerous possible bonding methods and the invention is not limited to a particular approach. For example, an alternative bonding approach to controlled chip collapse is with the use of anisotropic conductive adhesives.

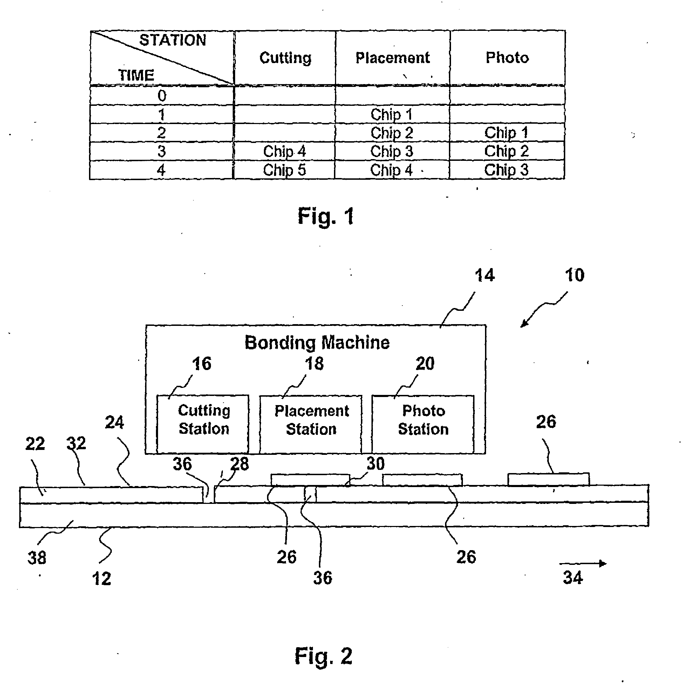

A preferred embodiment for bond site formation is exemplified in Figs. 1-3. Fig 1 shows a table of chip locations during a time sequence, and Fig. 2 shows a structural representative of a cut-on-fly apparatus 10. As can best be seen in Fig. 2, a substrate 12 moves under a bonding machine 14 from a cutting station 16 to a placement station 18 and then to a photo station 20. In this example, the cutting station 16 cuts a conductive layer 22 of metal and flux 24 at an estimated die attach area 28. The placement station 18 places a chip 26 onto the substrate 12 at a bond site 30, which includes the conductive layer 22, preferably at each time period, as will be discussed in greater detail below. The photo station 20 measures the location of a chip 26 to determine the location of a subsequent die attach area 32 that is to be cut. While not being limited to a particular theory, the photo station 20 is preferably a flash vision system that looks for an edge (*e.g*., front edge, rear edge) of each chip 26 passing by to determine the location of each chip.

Referring to Figs. 1 and 2, at Time 1, Chip 1 is placed at the bond site 30 on the conductive layer 22 of the substrate 12 as the substrate continuously moves down the line along a processing direction 34. At Time 2, which is subsequent to Time 1, Chip 1 is moved to the photo station 20 where a measurement of the chip's location is made, and Chip 2 is placed at the bond site 30 on the conductive layer 22 of the substrate 12 at the next die attach area. Based on the measurement of Chip 1, the system (*e.g*., bonding machine 14) preferably determines where subsequently placed chips 26 should be placed on the substrate 12. As one of ordinary skill in the art would readily understand, the position of the subsequently placed chip 26 can be determined from knowledge of the location of Chip 1 on the substrate 12 and the distance between successive chip placement locations. The distance between successive chip placement locations is understood as a function of the delta in time between chip placements and the speed of the non-stopping and non-reciprocating substrate 12 moving along the processing direction 34. The placement of each cut through the conductive layer 22 is between the estimated locations of where the conductive contact points of each deposited chip 26 will be located, that is, at the estimated die attach area 28, and is preferably midway between the contact points, which may be separated by microns (*e.g*., less than 10 µm to about 100 µm and most preferably between about 10 µm and 20 µm). Therefore, the dimensions of the chip 26 and its contact points should also be known in determining the cutting locations for subsequently placed chips.

Accordingly, based on the measurement of Chip 1's location, the bonding machine 14 determines where a subsequent chip should be placed and at Time 3 cuts the conductive layer 22 at the estimated die attach area 28 to form a gap 36 and an antenna for a subsequently placed chip. Since the substrate 12 is moving, at Time 3, which is subsequent to Time 2, Chip 1 is moved beyond the photo station 20, Chip 2 is at the photo station, and a new chip, Chip 3, is placed on the substrate 12 at the bond site 30 by the placement station 18. It should be noted that a cutter could also be used to cut the conductive layer under a chip 26 at other locations of the bonding machine 14, as will be described in greater detail below in conjunction with other preferred embodiments of the invention. However, in the most preferred embodiments, the conductive layer 22 is cut before the chip 26 is placed, which does not expose the chips to possible damage caused by cutting of the conductive layers, since the chips have not been placed and thus are not in danger from being damaged by the cutting station 16.

Still referring to Fig. 1, the substrate 12 continues down the line along the processing direction 34 and at Time 4, which is subsequent to Time 3, Chip 3 is at the photo station 20, where, if desired, the chip can be measured to determine the estimate die attach area 28 for a subsequently placed chip, as described above. Still at Time 4, the placement station 18 deposits Chip 4 at the bond site 30 on the substrate 12 over the gap 36 in the conductive layer (*e.g*., metal and flux layers) previously made at the cutting station 16. At this Time 4, the cutting station 16 cuts the conductive layer 22 to form the gap 36 for another subsequently placed chip (*e.g*., Chip 5).

Fig. 2 is an example illustration showing chip 26 and substrate 12 location under a bonding machine 14 at Time 4. While the photo station 20 is shown adjacent the placement station 18 , it is understood that the photo station can be located elsewhere along the line, as desired to accurately measure chip location for determination of subsequent cutting locations. The position of the photo station 20 may differ, for example, depending on the amount of time needed to measure and estimate subsequent die attach areas for chip placement. Accordingly, it is within the scope of the invention for the photo station 20 to be located anywhere after the placement station 18 down the line, as long as the photo (or measuring) station can measure the location of a deposited chip 26. In a similar manner, it is understood that while the cutting station 16 is shown above a die attach area 28 adjacent the placement station 18 and the bond site 30, the cutting station may be separated from the placement station by more than one placement intervals, where each placement interval is represented by the distance between successive die attach areas (*e.g*., consecutive chip placements).

As shown in Fig. 2, a first chip 26 (*e.g*., Chip 2) is located beyond the photo station 20, a second chip 26 (*e.g*., Chip 3) is located under the photo station, and a third chip 26 (*e.g*., Chip 4) is shown under the placement station 18 at the bond site over a gap 36 in the conductive layer 22 previously made by the cutting station 16. Another gap 36 in the conductive layer 22 is shown under the cutting station 16 at the estimated die attach area 28 for the next chip (*e.g*., Chip 5). It is understood that with this approach, the first three chips 26 in the process can not be used as a transponder since the conductive layer 22 under the chip has not been cut to remove the short and form an antenna. However, the loss of three chips 26 in a line is an insignificant sacrifice for the hundreds and thousands of subsequently placed chips that are safely and reliably made after the process begins.

Fig. 3 illustrates a preferred approach to placing the chips 26 down into the sticky flux 24 as the web goes by. Fig. 3 shows a rotating wheel 40 with vacuum heads 42 at the placement station 18. Each head 42 sucks a chip 26 out of a tube of aligned chips 44 at the top of the wheel's turn and blows the chips onto the bond side 30 at the bottom of its turn. Preferably, with the chips 26 placed upside down in the flux 24, the chip's solder bumps 46 are placed right into the conductive layer 22 for the conductive connection. Each chip 26 placed onto its bond site 30 continues with the substrate 12 to the photo station 20, and the welding station which solders the bond, for example, as discussed above.

While not being limited to a particular theory, the preferred embodiments of the invention provide at least the benefits of: less expensive tags; a high quality and high reliability integrated circuit attachment; greater output as bonding speeds compatible with flexographic printing lines are achieved by never stopping or even slowing down to do alignment; suitability for integration in current and foreseeable tag production lines is achieved by using flexographic print methodologies; and low total bond costs, for example, less than $0.01 at production volumes.

It is understood that the die attach area cut-on-fly method and apparatus described and shown are exemplary indications of preferred embodiments of the invention, and are given by way of illustration only. In other words, the concept of the present invention may be readily applied to a variety of preferred embodiments, including those disclosed herein.

## Claims

1. A method of applying respective transponders to at least one electrically conductive member to form a plurality of circuit components, said at least one electrically conductive member moving continuously down a path, each of said circuit components having a first conductive portion, a second conductive portion and a conductive gap (36) between the first and second conductive portion, the transponder being arranged to be secured to the first and second conductive portion bridging the conductive gap (36) therebetween, the method comprising:
determining the location of the conductive gap (36) in one of the plurality of circuit components while the at least one electrically conductive member is moving down said path;
placing a respective transponder adjacent the conductive gap (36), while the at least one electrically conductive member is moving down said path, based on the determined location of said conductive gap (36); and
electrically coupling respective portions of each respective transponder to respective ones of the first and second conductive portions across the conductive gap (36) to secure the respective transponder thereto.

2. The method of Claim 1, wherein the path comprises a portion of a high speed printing line.

3. The method of Claim 1 or 2, further comprising forming the conductive gap (36).

4. A bonding machine (14) adapted to apply respective transponders to at least one electrically conductive member to form a plurality of circuit components, said at least one electrically conductive member moving continuously down a path, each of said circuit components having a first conductive portion, a second conductive portion and a conductive gap (36) between the first and second conductive portion, the transponder being arranged to be secured to the first and second conductive portion bridging the conductive gap (36) therebetween, **characterized by**
a measuring station that determines the location of the conductive gap (36) in one of the plurality of circuit components while the at least one electrically conductive member is moving down said path;
a placement station (18) that places a respective transponder adjacent the conductive gap (36) while the at least one electrically conductive member is moving down said path based on the determined location of said gap (36) from the measuring station, said placement station (18) being adapted to electrically couple respective portions of each respective transponder to respective ones of the first and second conductive portions across the conductive gap (36) to secure the respective transponder thereto.

5. The bonding machine of Claim 4, wherein the path comprises a portion of a high speed printing line.

## Patentansprüche

1. Verfahren zum Aufbringen von Transpondern auf wenigstens ein elektrisch leitfähiges Teil, um eine Vielzahl von Schaltungskomponenten herzustellen, wobei sich das wenigstens eine elektrisch leitfähige Teil kontinuierlich auf einem Weg vorwärts bewegt, wobei jede der Schaltungskomponenten einen ersten leitfähigen Teil, einen zweiten leitfähigen Teil und einen leitfähigen Spalt (36) zwischen dem ersten und dem zweiten leitfähigen Teil hat, wobei der Transponder so angeordnet wird, dass er an dem ersten und dem zweiten leitfähigen Teil befestigt werden kann, wobei er den leitfähigen Spalt (36) zwischen denselben überbrückt, wobei das Verfahren beinhaltet:
Bestimmen der Lage des leitfähigen Spalts (36) in einem der mehreren Schaltungselemente, während sich das wenigstens eine elektrisch leitfähige Teil auf dem Weg vorwärts bewegt;
Platzieren eines Transponders an dem leitfähigen Spalt (36), während sich das wenigstens eine elektrisch leitfähige Teil auf dem Weg vorwärts bewegt, auf der Basis der ermittelten Lage des leitfähigen Spalts (36); und
elektrisches Verbinden von Teilen jedes Transponders mit jeweils einem der ersten und zweiten leitfähigen Teile über dem leitfähigen Spalt (36), um den Transponder daran zu befestigen.

2. Verfahren nach Anspruch 1, wobei der Weg einen Teil einer Hochgeschwindigkeitsdruckanlage umfasst.

3. Verfahren nach Anspruch 1 oder 2, weiter beinhaltend das Herstellen des leitfähigen Spalts (36).

4. Bondmaschine (14), die dafür ausgebildet ist, Transponder auf wenigstens ein elektrisch leitfähiges Teil aufzubringen, um eine Vielzahl von Schaltungskomponenten herzustellen, wobei sich das wenigstens eine elektrisch leitfähige Teil auf einem Weg kontinuierlich vorwärts bewegt, wobei jede der Schaltungskomponenten einen ersten leitfähigen Teil, einen zweiten leitfähigen Teil und einen leitfähigen Spalt (36) zwischen dem ersten und dem zweiten leitfähigen Teil hat, wobei der Transponder dafür ausgebildet ist, an dem ersten und dem zweiten leitfähigen Teil befestigt zu werden, wobei er den leitfähigen Spalt (36) zwischen denselben überbrückt, **gekennzeichnet durch**:
eine Messstation, die die Lage des leitfähigen Spalts (36) in einer der mehreren Schaltungskomponenten ermittelt, während sich das wenigstens eine elektrisch leitfähige Teil auf dem Weg vorwärts bewegt;
eine Bestückungsstation (18), die einen Transponder an dem leitfähigen Spalt (36) platziert, während sich das wenigstens eine elektrisch leitfähige Teil auf dem Weg vorwärts bewegt, auf der Basis der ermittelten Lage des Spalts (36) aus der Messstation, wobei die Bestückungsstation (18) dafür ausgebildet ist, Teile jedes Transponders jeweils mit den ersten und zweiten leitfähigen Teilen über den leitfähigen Spalt (36) zu verbinden, um den Transponder daran zu befestigen.

5. Bondmaschine nach Anspruch 4, wobei der Weg einen Teil einer Hochgeschwindigkeitsdruckanlage umfasst.

## Revendications

1. Procédé d'application de transpondeurs respectifs à au moins un élément électriquement conducteur pour former une pluralité de composants de circuit, ledit au moins un élément électriquement conducteur se déplaçant en continu le long d'un trajet, chacun desdits composants de circuit comportant une première partie conductrice, une deuxième partie conductrice et un espace conducteur (36) entre les première et deuxième parties conductrices, le transpondeur étant agencé pour être fixé aux première et deuxième parties conductrices enjambant l'espace conducteur (36) entre elles, le procédé comprenant les étapes consistant à :
déterminer l'emplacement de l'espace conducteur (36) dans l'un de la pluralité de composants de circuit alors que ledit au moins un élément électriquement conducteur se déplace le long dudit trajet ;
placer un transpondeur respectif à proximité de l'espace conducteur (36), alors que ledit au moins un élément électriquement conducteur se déplace le long dudit trajet, sur la base de l'emplacement déterminé dudit espace conducteur (36) ; et
coupler électriquement des parties respectives de chaque transpondeur respectif à des parties respectives des première et deuxième parties conductrices de part et d'autre de l'espace conducteur (36) pour fixer le transpondeur respectif à celles-ci.

2. Procédé selon la revendication 1, dans lequel le trajet comprend une partie d'une ligne d'impression à grande vitesse.

3. Procédé selon la revendication 1 ou 2, comprenant en outre l'étape consistant à former l'espace conducteur (36).

4. Machine à souder (14) adaptée pour appliquer des transpondeurs respectifs à au moins un élément électriquement conducteur pour former une pluralité de composants de circuit, ledit au moins un élément électriquement conducteur se déplaçant en continu le long d'un trajet, chacun desdits composants de circuit comportant une première partie conductrice, une deuxième partie conductrice et un espace conducteur (36) entre les première et deuxième parties conductrices, le transpondeur étant agencé pour être fixé aux première et deuxième parties conductrices enjambant l'espace conducteur (36) entre elles, **caractérisée par**
un poste de mesure qui détermine l'emplacement de l'espace conducteur (36) dans l'un de la pluralité de composants de circuit alors que ledit au moins un élément électriquement conducteur se déplace le long dudit trajet ;
un poste de placement (18) qui place un transpondeur respectif à proximité de l'espace conducteur (36) alors que ledit au moins un élément électriquement conducteur se déplace le long dudit trajet sur la base de l'emplacement déterminé dudit espace (36) par le poste de mesure, ledit poste de placement (18) étant adapté pour coupler électriquement des parties respectives de chaque transpondeur respectif à des parties respectives des première et deuxième parties conductrices de part et d'autre de l'espace conducteur (36) pour fixer le transpondeur respectif à celles-ci.

5. Machine à souder selon la revendication 4, dans laquelle le trajet comprend une partie d'une ligne d'impression à grande vitesse élevée.
